(19) Europäisches Patentamt / European Patent Office / Office européen des brevets

(11) EP 3 767 367 A1

(12) **EUROPEAN PATENT APPLICATION**
published in accordance with Art. 153(4) EPC

(43) Date of publication:
20.01.2021 Bulletin 2021/03

(21) Application number: 18909458.4

(22) Date of filing: 17.12.2018

(51) Int Cl.:
*G02B 26/10* (2006.01)   *B81B 3/00* (2006.01)
*B81B 7/04* (2006.01)   *G01S 7/481* (2006.01)
*G01S 17/93* (2020.01)   *G02B 26/08* (2006.01)

(86) International application number:
PCT/JP2018/046305

(87) International publication number:
WO 2019/176204 (19.09.2019 Gazette 2019/38)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 13.03.2018 JP 2018045774

(71) Applicant: Mitsubishi Electric Corporation
Tokyo 100-8310 (JP)

(72) Inventors:
• ITO, Takahiko
Tokyo 100-8310 (JP)
• KONNO, Nobuaki
Tokyo 100-8310 (JP)
• HIRATA, Yoshiaki
Tokyo 100-8310 (JP)

(74) Representative: Sajda, Wolf E.
Meissner Bolte Patentanwälte
Rechtsanwälte Partnerschaft mbB
Postfach 86 06 24
81633 München (DE)

(54) **OPTICAL SCANNING DEVICE AND METHOD OF CONTROL THEREFOR**

(57) The present invention provides an optical scanning device capable of optical scanning without reducing the spatial resolution even when the scanning range is expanded. The optical scanning device (100) comprises: a light source (101) emitting a light; a scanning mirror (106) that includes a reflecting plane reflecting a light entering from the light source (101) and that is allowed to oscillate independently around each of a first axis extending in the reflecting plane and a second axis orthogonal to the first axis and extending in the reflecting plane; and a controller (103) controlling the scanning mirror (106) in terms of a first frequency and a first amplitude of oscillation around the first axis as well as a second frequency and a second amplitude of oscillation around the second axis for scanning with the light reflected by the reflecting plane of the scanning mirror (106). The controller (103) controls the second frequency based on the maximum scanning angle in the sub-scanning direction.

Fig.1

**Description**

TECHNICAL FIELD

The present invention relates to an optical scanning device and a method of control therefor and, more particularly, to an optical scanning device capable of scanning a wide area with high spatial resolution and a method of control therefor.

BACKGROUND ART

An optical scanning device emitting light therearound for scanning is used in combination with light receiving means receiving the light and is thereby utilized as a distance measuring device measuring a distance to an object around the device. For example, Patent Document 1 discloses a light flight type distance measuring device for a vehicle capable of controlling a scanning range based on vehicle information such as a vehicle speed in a distance measuring device mounted on a vehicle.

PRIOR ART DOCUMENT

PATENT DOCUMENT

Patent Document 1: JP 2016-090268 A

SUMMARY OF THE INVENTION

PROBLEM TO BE SOLVED BY THE INVENTION

However, a distance measuring device capable of expanding a scanning range by changing a maximum scan angle $\gamma$ described in Patent Document 1 has a problem that spatial resolution is reduced when the scanning range is expanded.

An object of the present invention is to provide an optical scanning device capable of optical scanning without reducing the spatial resolution even when the scanning range is expanded.

MEANS FOR SOLVING PROBLEM

An embodiment of the present invention provides an optical scanning device comprising: a light source emitting a light; a scanning mirror that includes a reflecting plane reflecting a light entering from the light source and that is allowed to oscillate independently around each of a first axis extending in the reflecting plane and a second axis orthogonal to the first axis and extending in the reflecting plane; and a controller controlling the scanning mirror in terms of a first frequency and a first amplitude of oscillation around the first axis as well as a second frequency and a second amplitude of oscillation around the second axis for scanning with the light reflected by the reflecting plane of the scanning mirror, the optical scanning device scanning, with the light emitted from the light source, the inside of a scanning range defined by a maximum scanning angle in a main scanning direction changing in accordance with the first amplitude and a maximum scanning angle in a sub-scanning direction orthogonal to the main scanning direction and changing in accordance with the second amplitude. The controller controls the second frequency based on the maximum scanning angle in the sub-scanning direction.

EFFECT OF THE INVENTION

According to the present invention, the optical scanning device capable of preventing a reduction in spatial resolution can be obtained by controlling a frame rate based on information such as acceleration and angular velocity.

BRIEF DESCRIPTION OF DRAWINGS

FIG. 1 is a schematic drawing showing an optical scanning device according to a first embodiment of the present invention and a vehicle equipped with the optical scanning device.
FIG. 2 is a schematic top view of a substrate of the optical scanning device according to the first embodiment of the present invention.
FIG. 3 is a schematic cross-sectional view of a two-dimensional scanning mirror of the substrate of FIG. 2 as viewed in a direction III-III.
FIG. 4 is a schematic cross-sectional view of an acceleration sensor of the substrate of FIG. 2 as viewed in a direction IV-IV.
FIG. 5 is a schematic cross-sectional view of the acceleration sensor of the substrate of FIG. 2 as viewed in a direction V-V.
FIG. 6 is a schematic cross-sectional view of an SOI substrate before processing.
FIG. 7 is a schematic drawing showing the relationship between a tilt angle of a mirror part of the two-dimensional scanning mirror and a traveling direction of a light beam reflected by the mirror part.
FIG. 8 is a schematic drawing showing a scanning range of a light beam emitted from the optical scanning device according to the first embodiment of the present invention.
FIG. 9 is a schematic drawing showing an example of a scanning path and scanning points of the light beam emitted from the optical scanning device according to the first embodiment of the present invention.
FIG. 10 is a graph showing an example of a relationship between acceleration and a maximum scanning angle of the optical scanning device according to the first embodiment of the present invention.

FIG. 11 is a schematic drawing showing a scanning path and scanning points of a conventional distance measuring device during acceleration.

FIG. 12 is a schematic drawing showing a scanning path and scanning points of the conventional distance measuring device during deceleration.

FIG. 13 is a flowchart showing a method of changing a drive frequency (frame rate) in accordance with acceleration without deteriorating spatial resolution.

FIG. 14 is a schematic drawing showing a scanning path and scanning points of the optical scanning device of the first embodiment of the present invention.

FIG. 15 is a flowchart showing a method of changing the maximum scanning angle in accordance with acceleration without deteriorating spatial resolution.

FIG. 16 is a graph showing an example of a relationship between acceleration and a drive frequency (frame rate) of the optical scanning device according to the first embodiment of the present invention.

FIG. 17 is a schematic drawing showing a configuration of an optical scanning device according to a first modification of the first embodiment of the present invention.

FIG. 18 is a schematic drawing showing a configuration of an optical scanning device according to a second modification of the first embodiment of the present invention.

FIG. 19 is a schematic drawing showing a configuration of an optical scanning device according to a second embodiment of the present invention.

FIG. 20 is a graph showing an example of a relationship between an angular velocity and a maximum scanning angle of the optical scanning device according to the second embodiment of the present invention.

FIG. 21 is a schematic drawing showing a scanning path and scanning points of the conventional distance measuring device during straight running.

FIG. 22 is a schematic drawing showing a scanning path and scanning points of the conventional distance measuring device during turning.

FIG. 23 is a flowchart showing a method of changing a drive frequency (frame rate) in accordance with an angular velocity without deteriorating spatial resolution.

FIG. 24 is a schematic drawing showing a scanning path and scanning points of the optical scanning device of the second embodiment of the present invention.

FIG. 25 is a schematic drawing showing a configuration of an optical scanning device according to a third embodiment of the present invention.

FIG. 26 is a schematic top view of a substrate of the optical scanning device according to the third embodiment of the present invention.

FIG. 27 is a schematic cross-sectional view of a two-dimensional scanning mirror of the substrate of FIG. 26 as viewed in a direction XXV-XXV.

FIG. 28 is a schematic drawing showing an optical axis of a light beam emitted from the optical scanning device according to the third embodiment of the present invention.

FIG. 29 is a schematic drawing showing a vehicle equipped with the optical scanning device according to the third embodiment of the present invention.

FIG. 30 is a schematic drawing showing a scanning path and scanning points of the optical scanning device according to the third embodiment of the present invention.

FIG. 31 is a schematic drawing showing a scanning path and scanning points of the optical scanning device according to the third embodiment of the present invention when the maximum scanning angle is increased from FIG. 30 without changing an amplitude change frequency (frame rate).

FIG. 32 is a flowchart showing a method of changing an amplitude change frequency (frame rate) in accordance with acceleration without deteriorating spatial resolution.

FIG. 33 is a schematic drawing showing a scanning path and scanning points of the optical scanning device according to the third embodiment of the present invention.

FIG. 34 is a schematic drawing showing a configuration of an optical scanning device according to a fourth embodiment of the present invention.

FIG. 35 is a graph showing an example of a relationship between a velocity and a maximum scanning angle of the optical scanning device according to the fourth embodiment of the present invention.

FIG. 36 is a flowchart showing a method of changing a drive frequency in accordance with a velocity without deteriorating spatial resolution.

MODES FOR CARRYING OUT THE INVENTION

An optical scanning device according to an embodiment of the present invention will now be described with reference to the drawings. In each embodiment, the same constituent elements are denoted by the same reference numerals and will not be described.

First Embodiment

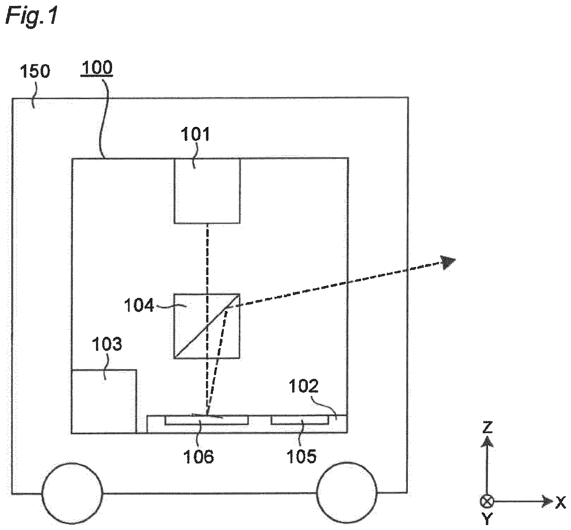

FIG. 1 is a schematic drawing showing an optical scanning device according to a first embodiment of the present invention, which is generally denoted by 100, and a vehicle 150 equipped with the optical scanning device 100. As shown in FIG. 1, the optical scanning device 100 is typically mounted on the vehicle 150 such as an automobile.

The optical scanning device 100 includes a light source 101 emitting a beam-shaped laser beam (hereinafter referred to as "light beam"), a beam splitter 104 on which the light beam emitted from the light source 101 is made incident and that transmits a portion of the incident light while reflecting the other portion, and a substrate 102 on which the light beam emitted from the light source 101 is made incident via the beam splitter 104.

The substrate 102 includes an acceleration sensor 105 for detecting the acceleration of the optical scanning device 100 and a two-dimensional scanning mirror 106 capable of changing a direction of an optical axis of the incident light beam. The optical scanning device 100 further includes a controller 103 controlling an attitude of the two-dimensional scanning mirror 106 based on the acceleration detected by the acceleration sensor 105.

In this description, an X axis, a Y axis, and a Z axis are introduced for convenience of description. As shown in FIG. 1, a surface of the substrate 102 extends in the X direction and the Y direction perpendicular to the X direction. The Y direction is a direction perpendicular to the plane of FIG. 1. The Z direction is defined as a direction perpendicular to the X axis and the Y axis. In the following figures, a path of the light beam is indicated by a broken line.

For example, the light source 101 is a laser diode (LD) element or a light-emitting diode element (LED); however, the present invention is not limited thereto. A collimator lens (not shown) adjusting a diffused light into a parallel light flux may be disposed on a subsequent stage of the light source 101 (between the light source 101 and the beam splitter 104).

The substrate 102 is arranged such that the optical axis of the light beam emitted from the light source 101 passes through the center of the two-dimensional scanning mirror 106 via the beam splitter 104. As a result, the light beam emitted from the light source 101 passes through the beam splitter 104 and enters the center of the two-dimensional scanning mirror 106. The light beam reflected by the two-dimensional scanning mirror 106 enters the beam splitter 104 again. At least a portion of the light entering the beam splitter 104 is reflected by the beam splitter 104 and emitted from the optical scanning device 100 in the X direction.

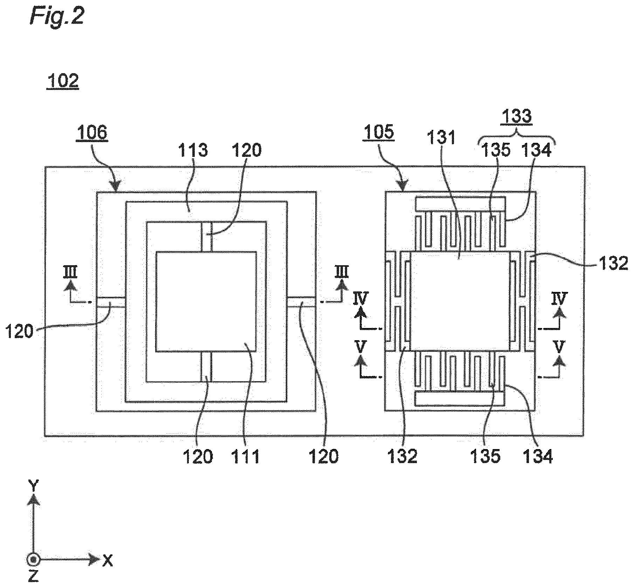

FIG. 2 is a schematic top view of the substrate 102. The two-dimensional scanning mirror 106 of the substrate 102 includes a mirror part 111 reflecting light and attached rotatably around the X-axis and a frame 113 attached rotatably around the Y axis to surround a periphery of the mirror part 111 at a distance from the mirror part 111 in planar view.

Both ends in the Y direction of the mirror part 111 are respectively connected to the frame 113 via beams 120 having flexibility allowing bending in a longitudinal direction. Both outer ends in the X direction of the frame 113 are respectively connected via the beams 120 to the substrate 102.

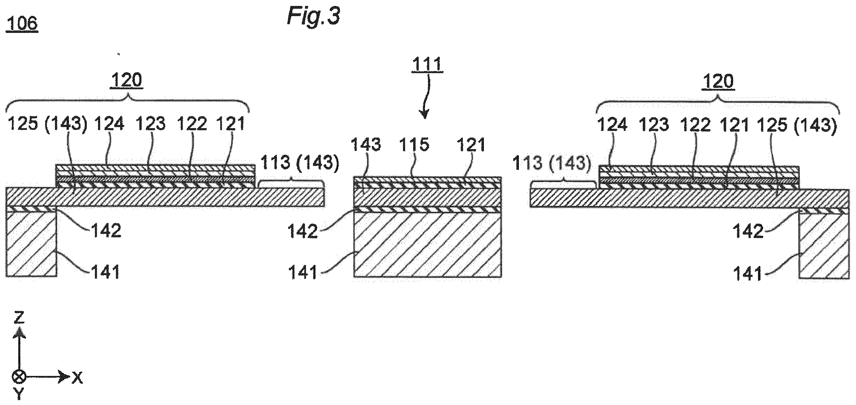

FIG. 3 is a schematic cross-sectional view of the two-dimensional scanning mirror 106 of the substrate 102 of FIG. 2 as viewed in a direction III-III. For example, the two-dimensional scanning mirror 106 is formed on an SOI (silicon on insulator) substrate composed of a support layer 141 made of non-conductive single-crystal silicon, an insulating layer 142 formed on the support layer 141, and an active layer 143 formed on the insulating layer 142. The insulating layer 142 is a silicon oxide film, for example. The active layer 143 is a conductive single-crystal silicon layer having conductivity due to addition of impurities, for example.

An insulating film 121 is formed on the active layer 143 of the two-dimensional scanning mirror 106. A reflection film 115 reflecting light on a surface is formed on the insulating film 121 of the mirror part 111. The reflection film 115 is made of, for example, Au (gold); however, the present invention is not limited thereto.

The beams 120 are each composed of a beam base 125 that is a portion of the active layer 143, the insulating film 121 formed on the beam base 125, a first electrode 122 formed on the insulating film 121, a piezoelectric film 123 formed on the first electrode 122, and a second electrode 124 formed on the piezoelectric film 123. The first electrode 122 is made of Pt (platinum), for example. The piezoelectric film 123 is made of lead zirconate titanate (PZT), for example. The second electrode 124 is made of Au (gold), for example.

The first electrode 122 and the second electrode 124 of the beam 120 of the two-dimensional scanning mirror 106 are electrically insulated. The first electrode 122 and the second electrode 124 are respectively electrically connected via separate wirings (not shown) to an external power supply (not shown).

A piezoelectric material of the piezoelectric film 123 is pre-treated to have polarization in a thickness direction (Z-axis direction). As a result, when an electric field is applied downward (in a negative Z-axis direction) to the piezoelectric film 123, the piezoelectric film 123 extends in an in-plane direction, and the beam 120 warps into an upward convex shape. Therefore, an end portion of the beam 120 can be displaced downward.

Conversely, when an electric field is applied upward (in a positive Z-axis direction) to the piezoelectric film 123, the piezoelectric film 123 contracts in the in-plane direction, and the beam 120 warps into a downward convex shape. Therefore, the end portion of the beam 120 can be displaced upward.

In this way, by applying a potential to the first electrode 122 and the second electrode 124 to apply an electric field to the piezoelectric film 123, the beam 120 is deformed in the Z direction to rotate the two-dimensional scanning mirror 106 around the X-axis or the Y-axis. For example, a connection portion between the beam 120 and the mirror part 111, and a connection portion between the beam 120 and the frame 113 (see FIG. 2) are displaced in the Z direction.

When the connection portion between the beam 120 and the mirror part 111 is displaced in the Z direction, the mirror part 111 rotates around the X axis. When the connection portion between the beam 120 and the frame 113 is displaced in the Z direction, the mirror part 111 rotates around the Y axis (since the frame 113 rotates around the Y axis).

Since the expansion and contraction can be controlled by the direction of the electric field applied to the piezoelectric film 123, the direction of warpage of the beam 120 can be changed by controlling the sign of the applied voltage. Additionally, the curvature of the warpage can be changed by controlling the magnitude of the applied voltage. Therefore, the deformation of the beam 120 can be controlled by the polarity and the magnitude of the applied voltage.

By disposing the two beams 120 at positions opposite to each other across the mirror part 111 in the positive and negative directions of the X axis, the mirror part 111 can be rotated around the Y axis. Furthermore, by disposing the two beams 120 at positions opposite to each other across the mirror part 111 in the positive and negative directions of the X axis, the mirror part 111 can be rotated around the X axis independently of the rotation around the Y axis.

In the example described above, the mirror part 111 of the two-dimensional scanning mirror 106 is supported by the four beams 120, and the piezoelectric film 123 is disposed on each of the beams 120 (see FIGS. 2 and 3). However, the number, arrangement, and shape of the beams 120 and the type, arrangement, and shape of the piezoelectric film 123 are not limited to those described above as long as the direction of the optical axis of the light beam can be changed by changing the tilt angle of the mirror part 111.

In the example described above, the electric field is applied to the piezoelectric film 123 disposed on the beam 120 to deform the piezoelectric film 123 and the beam 120, so that the tilt angle of the mirror part 111 is changed (see FIG. 3). However, the mechanism changing the tilt angle of the mirror part 111 is not limited to the mechanism described above as long as the direction of the optical axis of the light beam can be changed by changing the tilt angle of the mirror part 111.

For example, the tilt angle of the mirror part 111 may be changed by using an electrostatic attractive force generated by applying a voltage to an electrode, or an electromagnetic force generated by causing a current to flow through a wiring disposed on a substrate while applying a magnetic field.

In FIG. 2, the shape of the mirror part 111 of the two-dimensional scanning mirror 106 is a quadrangle in planar view; however, the present invention is not limited thereto.

The mirror part 111 has a mechanical specific resonance frequency (also referred to as a natural frequency) fyc in terms of oscillation around the Y axis. Generally, when a structure is oscillated, oscillating the structure at a specific resonance frequency can result in efficient conversion of applied energy into oscillation. Regarding the mirror part 111 (see FIG. 3) of the two-dimensional scanning mirror 106, a drive frequency of a signal applied to the piezoelectric film 123 of each of the beams 120 of the two-dimensional scanning mirror 106 is controlled so that resonance occurs around the axis.

Alternatively, conversely, the material, shape, and mass of the parts of the two-dimensional scanning mirror 106 are designed in accordance with the drive frequency of the signal so that resonance occurs around the axis. As a result, a larger amplitude can be obtained at the same applied voltage as compared to when no resonance occurs.

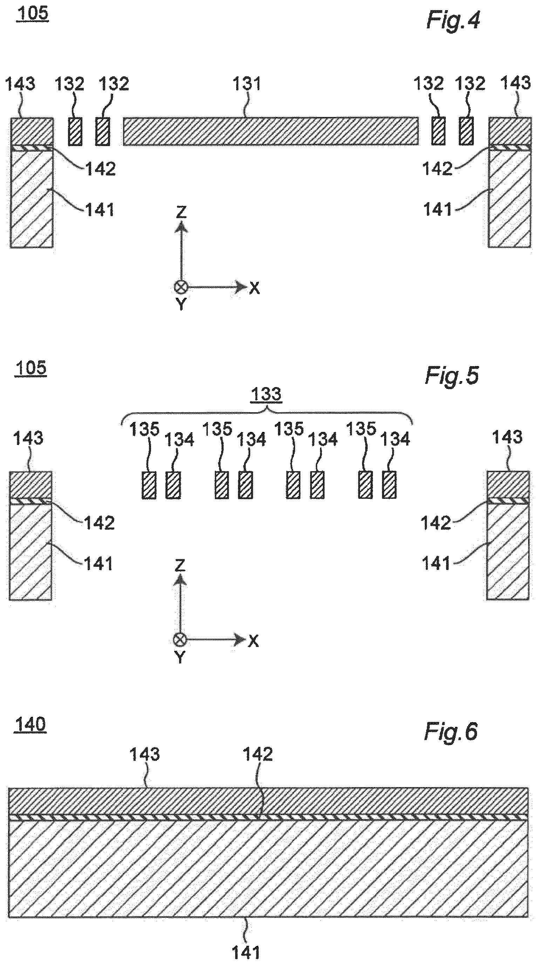

On the other hand, FIG. 4 is a schematic cross-sectional view of the acceleration sensor 105 of the substrate 102 of FIG. 2 as viewed in a direction IV-IV. FIG. 5 is a schematic cross-sectional view of the acceleration sensor 105 of the substrate 102 in FIG. 2 as viewed in a direction V-V.

Referring to FIGS. 2, 4, and 5, the acceleration sensor 105 of the substrate 102 includes an inertial mass body 131, two beams 132 arranged to sandwich the inertial mass body 131 from both sides in the X direction so that the inertial mass body 131 is supported to be displaceable in the in-plane direction (i.e., in the X direction), and comb-teeth electrodes 133 arranged to sandwich the inertial mass body 131 in the Y direction.

The comb-teeth electrodes 133 are each made up of multiple fixed comb-teeth electrodes 134 each connected to the substrate 102 and multiple movable comb-teeth electrodes 135 each connected to the inertial mass body 131. The fixed comb-teeth electrodes 134 and the movable comb-teeth electrodes 135 are alternately and closely arranged in the X direction to form an electrostatic capacity.

The fixed comb-teeth electrodes 134 and the movable comb-teeth electrodes 135 of the acceleration sensor 105 are electrically insulated. The fixed comb-teeth electrodes 134 and the movable comb-teeth electrodes 135 are respectively electrically connected to separate conductive substrates (not shown) and respectively electrically connected to external electric circuits (not shown) via bonding pads (not shown) electrically connected to the conductive substrates.

When the optical scanning device 100 is accelerated or decelerated in the X direction, the movable comb-teeth electrodes 135 are displaced in the X direction relative to the fixed comb-teeth electrodes 134 in accordance with the inertial mass body 131. As a result, an electrostatic capacity between the fixed comb-teeth electrodes 134 and the movable comb-teeth electrodes 135 is changed. Since the displacement amount of the inertial mass body 131 depends on the acceleration thereof, the acceleration of the optical scanning device 100 can be detected by measuring the electrostatic capacity.

In the above description, the acceleration sensor 105 has the fixed comb-teeth electrodes 134 and the movable comb-teeth electrodes 135 and detects the acceleration of the optical scanning device 100 based on a change in electrostatic capacity. However, the shape of the electrodes is not limited to the comb shape, and the number and arrangement of the electrodes are not limited to those described above with reference to FIGS. 2 and 5. Means for detecting the acceleration of the optical scanning device 100 is not limited to means based on a change in electrostatic capacity.

For example, the acceleration of the optical scanning device 100 can be detected by supporting the inertial mass body 131 by beams made of single-crystal silicon, forming a strain gauge on the beam by means such as impurity diffusion, and detecting an inertial force applied to the inertial mass body 131 by using a piezoresistance effect.

In the above description, as shown in FIGS. 2 and 4, the acceleration sensor 105 has the two beams 132 arranged to sandwich the inertial mass body 131 from both sides in the X direction so that the inertial mass body 131 is supported to be displaceable in the X direction. However, the number, arrangement, and shape of the beams 132 are not limited to those described above as long as the inertial mass body 131 can be supported to be displaceable.

A method of manufacturing the optical scanning device 100 will be described.

The acceleration sensor 105 and the two-dimensional scanning mirror 106 are manufactured by using a so-called semiconductor microfabrication technique or a MEMS device technique including repeatedly performing processes such as film formation, patterning, and etching on a substrate, for example. FIG. 6 is a schematic cross-sectional view of an SOI substrate 140 before processing. The SOI substrate 140 is composed of the supporting layer 141 made of non-conductive single-crystal silicon, the insulating layer 142 formed on the supporting layer 141, and the active layer 143 formed on the insulating layer 142. The insulating layer 142 is a silicon oxide film, for example. The active layer 143 is a conductive single-crystal silicon layer having conductivity due to addition of impurities, for example.

For example, the structures of the two-dimensional scanning mirror 106 (see FIG. 3) and the acceleration sensor 105 (see FIGS. 4 and 5) are obtained by performing the following steps 1 to 6 for the SOI substrate 140 (see FIG. 6).

> Step 1: The insulating film 121 (e.g., a silicon oxide film) is formed and patterned on the active layer 143 of the SOI substrate 140.
> Step 2: The first electrode 122 (e.g., Pt) is formed and patterned on the insulating film 121.
> Step 3: The piezoelectric film 123 (e.g., a PZT film) is formed and patterned on the first electrode 122.
> Step 4: The second electrode 124 (e.g., Au) is formed and patterned on the piezoelectric film 123.
> Step 5: Portions of the support layer 141 and the active layer 143 of the SOI substrate 140 are etched.
> Step 6: A desired portion of the insulating film 121 is etched.

However, the method of manufacturing the optical scanning device 100 is not limited to the processing of the SOI substrate 140 and may be any method as long as the acceleration sensor 105 and the two-dimensional scanning mirror 106 can be formed on the same substrate. For example, after a thermal oxide film is formed by annealing on a single-crystal silicon substrate, a conductive polycrystalline silicon layer may be formed, and steps 1 to 6 described above may then be performed on this substrate.

Furthermore, the two-dimensional scanning mirror 106 is not limited to a so-called MEMS mirror manufactured by the semiconductor microfabrication technique as described above. The acceleration sensor 105 is not limited to a MEMS acceleration sensor. For example, the acceleration sensor 105 may be a mechanical acceleration sensor made up of a spring and a weight, or an acceleration sensor optically detecting a displacement of the inertial mass body 131 (see, e.g., FIG. 2).

In the example described above, the mirror part 111 of the two-dimensional scanning mirror 106 has a thickness greater than the beams 120 (see FIG. 3). This is for the purpose of reducing the deflection of the reflection film 115 of the mirror part 111 of the two-dimensional scanning mirror 106 as far as possible. However, the mirror part 111 may be any mirror part as long as the direction of the optical axis of the light beam can be changed by changing the tilt angle thereof, and the thickness of the mirror part 111 of the two-dimensional scanning mirror 106 is not limited to the thickness described above.

An operation of the optical scanning device 100 will hereinafter be described.

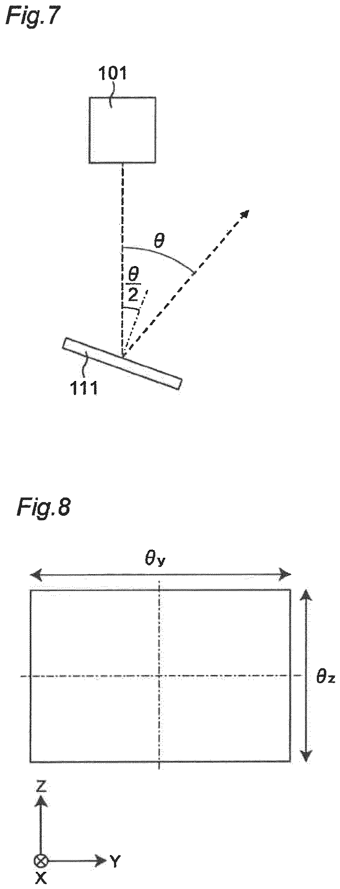

FIG. 7 is a schematic drawing showing a relationship between the tilt angle of the mirror part 111 of the two-dimensional scanning mirror 106 and a traveling direction of a light beam reflected by the mirror part 111. When the mirror part 111 is tilted by $\theta/2$ from a horizontal state, the normal line of the mirror part 111 is also tilted by $\theta/2$, so that the angle formed by the optical axis of the reflected light and the optical axis of the incident light is $\theta$.

Referring to FIG. 1 again, when the mirror part 111 of the two-dimensional scanning mirror 106 is rotated around the X axis, the traveling direction of the light beam reflected by the mirror part 111 toward the beam splitter 104 moves in a Y-Z plane.

Therefore, the traveling direction of the light beam reflected by the beam splitter 104 and emitted from the optical scanning device 100 in the X direction moves in an X-Y plane. Similarly, when the mirror part 111 of the two-dimensional scanning mirror 106 is rotated around the Y axis, the traveling direction of the light beam emitted from the optical scanning device 100 in the X direction moves in a Z-X plane.

By respectively controlling the voltages applied to the piezoelectric films 123 (see FIG. 3) of the beams 120 of the two-dimensional scanning mirror 106, the mirror part 111 can be oscillated around the X axis at a constant frequency and can also be oscillated around the Y axis at a constant frequency. By controlling the frequencies, scanning can be performed with the light beam emitted from the optical scanning device 100.

FIG. 8 is a schematic drawing showing a scanning range (angle) of the light beam emitted from the optical scanning device 100. The light beam is emitted from the optical scanning device 100 in the X direction, scans in a range of a maximum scanning angle θy in the Y-axis direction, and scans in a range of a maximum scanning angle θz in the Z-axis direction.

Therefore, the light beam emitted from the optical scanning device 100 can scan within a rectangular range schematically shown in FIG. 8. The maximum scanning angles θy, θz are controlled a magnitude and a sign of a voltage (hereinafter, referred to as "drive voltage") V applied to the piezoelectric film 123 (see FIG. 3).

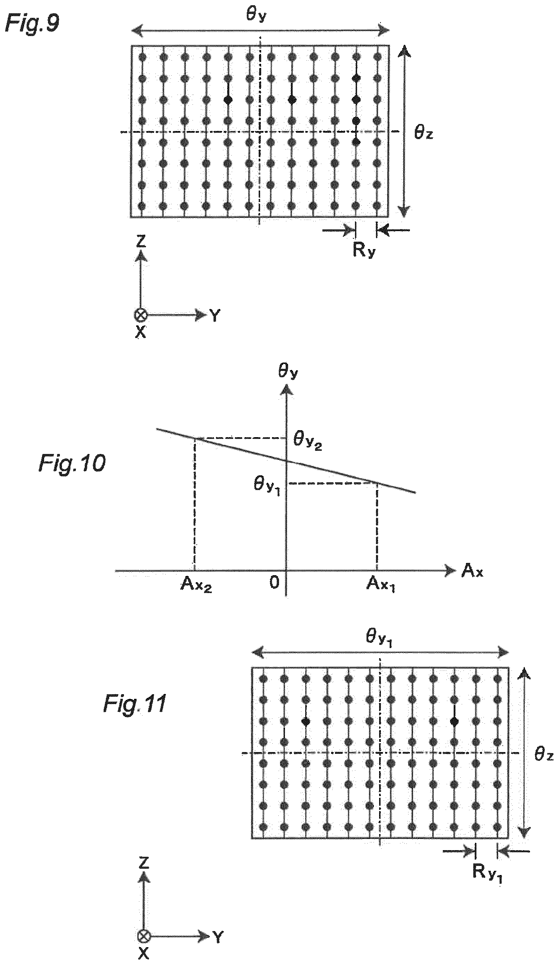

FIG. 9 is a schematic showing an example of a scanning path of the light beam for scanning within the scanning range of FIG. 8. In FIG. 9, scanning points irradiated with a pulsed laser beam emitted at regular intervals from the optical scanning device 100 are schematically indicated by black circles. In FIG. 9, a locus of the light beam is indicated by a solid line for convenience of description.

As described above, when the mirror part 111 of the two-dimensional scanning mirror 106 is rotated around the Y axis, the light beam emitted from the optical scanning device 100 in the X direction moves in the Z-X plane to scan one column vertically (in a main scanning direction) on the plane of the figure. When the mirror part 111 is rotated around the X axis, the light beam emitted from the optical scanning device 100 in the X direction moves in the X-Y plane, and the scanning path of the light beam moves horizontally (in a sub-scanning direction).

By combining the rotation around the X axis and the rotation around the Y axis of the mirror part 111 of the two-dimensional scanning mirror 106, a matrix of the scanning points as shown in FIG. 9 is achieved.

The frequency of oscillation around the X axis and the frequency of oscillation around the Y axis of the mirror part 111 of the two-dimensional scanning mirror 106 will be denoted by fx and fy, respectively. The scanning as shown in FIG. 9 can be performed by setting the frequencies as in Eqs. (1) and (2) below:

$$fy = fyc \qquad \ldots(1)$$

$$fx = fy/n \qquad \ldots(2)$$

where n is an integer determined by Eq. (3) below,

$$n = \theta y / Ry \qquad \ldots(3)$$

where Ry is an angular interval (hereinafter referred to as "spatial resolution") between a column (main scanning line) and a next column (main scanning line) in the matrix of the scanning points of FIG. 9.

Eq. (4) below is derived from Eqs. (1) to (3).

$$fx \times (\theta y / Ry) = fyc \qquad \ldots(4)$$

When Eqs. (1) and (2) are satisfied, the optical scanning device 100 can scan in the same direction in a period of 1/fx (i.e., the same scanning points in FIG. 9 can periodically be irradiated with the light beam). Hereinafter, the frequency fx of oscillation around the X axis of the mirror part 111 of the two-dimensional scanning mirror 106 will be referred to as "drive frequency" or "frame rate".

As described above, the optical scanning device 100 can scan with the light beam and is therefore applicable to a distance measuring device measuring a distance between the optical scanning device 100 and an object therearound and recognizing surrounding conditions. For example, when the vehicle 150 (see FIG. 1) runs in the X direction, the optical scanning device 100 can measure a distance in the running direction to check whether an obstacle exists in the running direction.

Generally, when a vehicle is accelerated, for example, when a stopped vehicle starts moving, a running speed will increase in the future, so that a distance measuring device mounted on the vehicle is desirably capable of scanning a distant place with high spatial resolution. On the other hand, when the vehicle is decelerated, for example, when the running vehicle stops, the running speed will decrease in the future, and the running direction of the vehicle is more likely to rapidly change, so that the distance measuring device mounted on the vehicle desirably scans a wide range especially in the horizontal direction.

Therefore, as shown in FIG. 10, the maximum scanning angle θy has hitherto been changed in accordance with a vehicle acceleration Ax such that the maximum scanning angle θy is reduced when the acceleration is positive (acceleration) while the maximum scanning angle θy is increased when the acceleration is negative (deceleration).

FIG. 10 shows an example of a relationship between the acceleration Ax and the maximum scanning angle θy when the maximum scanning angle θy is adjusted in accordance with the acceleration Ax. A graph of FIG. 10 shows that the maximum scanning angle θy is adjusted to θy$_1$ at the time of an acceleration Ax$_1$ (during acceleration) and is adjusted to θy$_2$ (>θy$_1$) at the time of an acceleration Ax$_2$ (during deceleration).

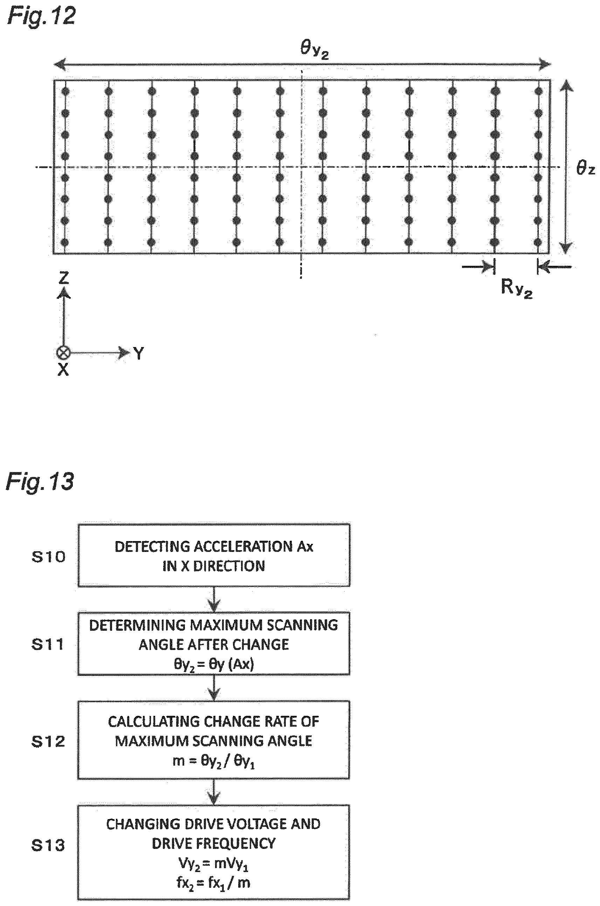

FIG. 11 is a schematic drawing showing a scanning path and scanning points of a conventional distance measuring device during acceleration (at the time of the acceleration Ax$_1$ of FIG. 10). As shown in FIG. 11, a spatial resolution Ry in this case is Ryi. FIG. 12 is a schematic drawing showing a scanning path and scanning points of the conventional distance measuring device during deceleration (at the time of the acceleration $Ax_2$ of FIG. 10). The spatial resolution Ry in this case is $Ry_2$.

In FIG. 12 showing the case of deceleration, the scanning points are sparser in the Y direction as compared to FIG. 11 showing the case of acceleration, and the spatial resolution Ry is deteriorated (i.e., Ry1<Ry2). As described above, the prior art has a problem of deterioration in the spatial resolution Ry when the maximum scanning angle θy is increased.

Therefore, the optical scanning device 100 according to the first embodiment controls the drive frequency (frame rate) fx such that the spatial resolution Ry does not deteriorate even when the maximum scanning angle θy is changed in accordance with the acceleration Ax of the vehicle 150.

When it is desired to keep the spatial resolution Ry constant even when the maximum scanning angle θy is changed, the drive frequency (frame rate) fx may be controlled such that $fx \times \theta y$ is made constant, from Eq. (4), since both Ry and fyc are constants. For example, when the maximum scanning angle θy is doubled, the spatial resolution Ry is kept constant by reducing the drive frequency (frame rate) fx to 1/2.

FIG. 13 is a flowchart showing a method of changing the drive frequency (frame rate) fx in accordance with the acceleration Ax without deteriorating the spatial resolution Ry. Before the change, the drive frequency (frame rate) fx is $fx_1$, the drive voltage V is $Vy_1$, and the maximum scanning angle θy is $\theta y_1$. First, at step S10, the acceleration sensor 105 (see FIGS. 1 and 2) of the optical scanning device 100 detects the acceleration Ax in the X direction.

At next step S11, the controller 103 (see FIG. 1) determines the maximum scanning angle $\theta y_2$ after the change based on the detected acceleration Ax. For example, when the acceleration Ax is negative (during deceleration), the determination is made to satisfy $\theta y_2 > \theta y_1$.

At step S12, the controller 103 calculates a rate (maximum scanning angle change rate) m of the maximum scanning angle $\theta y_2$ after the change to the maximum scanning angle $\theta y_1$ before the change ($m = \theta y_2/\theta y_1$).

Lastly, at step S13, the controller 103 sets the drive voltage to $Vy_2$ (= $mVy_1$) to change the maximum scanning angle to $\theta y_2$ and changes the drive frequency (frame rate) to $fx_2$ (= $fx_1/m$) to maintain the relationship of Eq. (4).

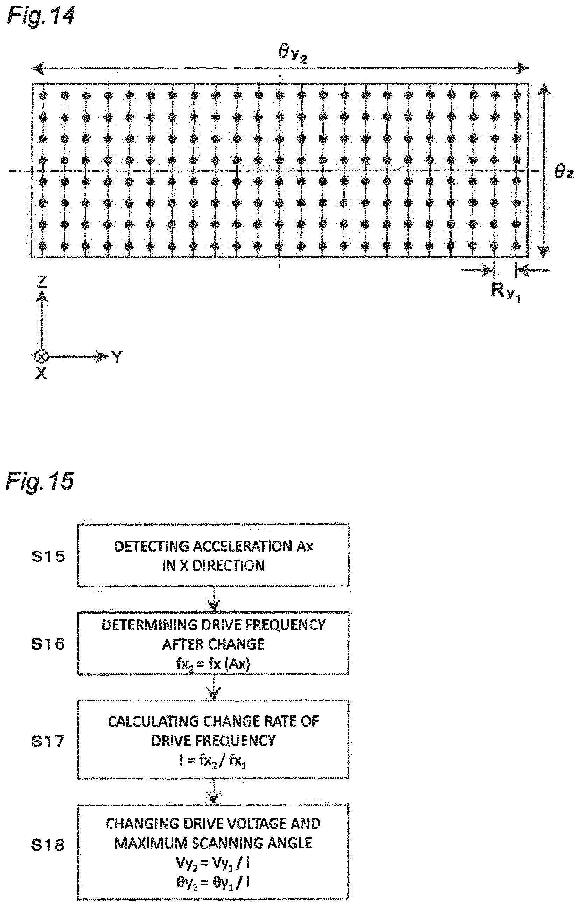

FIG. 14 is a schematic drawing showing a scanning path and scanning points of the optical scanning device 100 of the first embodiment of the present invention when the drive frequency fx is adjusted in this way. FIG. 14 shows an example in the case of m = 2, i.e., when the maximum scanning angle θy is doubled. In FIG. 14, it can be seen that the spatial resolution Ry is $Ry_1$, which is not change from the spatial resolution during acceleration (see FIG. 11).

As described above, the optical scanning device 100 according to the first embodiment of the present invention can control the maximum scanning angle θy of the light beam based on the acceleration Ax and control the drive frequency (frame rate) fx so as to keep the spatial resolution Ry constant even when the maximum scanning angle θy is changed.

Another method may be employed to keep the spatial resolution Ry constant. For example, if it is desired to detect a behavior of a specific object in the running direction at a high frame rate, the spatial resolution Ry can be kept constant by controlling the maximum scanning angle θy based on the target drive frequency (frame rate) fx.

FIG. 15 is a flowchart showing a method of controlling the maximum scanning angle θy based on the drive frequency (frame rate) fx without deteriorating the spatial resolution Ry. Before the change, the drive frequency (frame rate) fx is $fx_1$, the drive voltage V is $Vy_1$, and the maximum scanning angle θy is $\theta y_1$. First, at step S15, the acceleration sensor 105 (see FIGS. 1 and 2) of the optical scanning device 100 detects the acceleration Ax in the X direction.

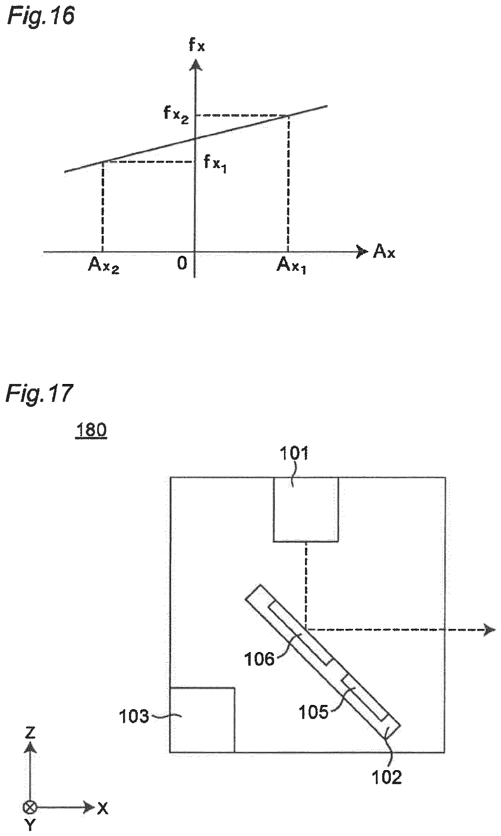

At next step S16, the controller 103 (see FIG. 1) determines the drive frequency (frame rate) $fx_2$ after the change based on the detected acceleration Ax. For example, as shown in FIG. 16, when the acceleration Ax is positive (during acceleration), the determination is made to satisfy $fx_2 > fx_1$.

At step S17, the controller 103 calculates a rate (drive frequency change rate) 1 of the drive frequency (frame rate) $fx_2$ after the change to the drive frequency (frame rate) $fx_1$ before the change (1 = $fx_2/fx_1$).

Lastly, at step S18, the controller 103 changes the maximum scanning angle to $\theta y_2$ (= $\theta y_1/1$) to maintain the relationship of Eq. (4). To change the maximum scanning angle to $\theta y_2$ (= $\theta y_1/1$), the drive voltage may be set to $Vy_2$ (=$Vy_1/1$).

In the optical scanning device 100 according to the first embodiment, the acceleration sensor 105 and the two-dimensional scanning mirror 106 are formed on the same substrate 102 (see FIGS. 1 and 2). Therefore, when attached to a device such as the vehicle 150 (see FIG. 1), the optical scanning device 100 has an advantage that it is not necessary to adjust relative positions therebetween. However, the present invention is not limited thereto, and the acceleration sensor 105 and the two-dimensional scanning mirror 106 may be formed on different substrates.

In the case of the above description, the drive frequency fx of the oscillation around the X axis is 1/n of the drive frequency fy of the oscillation around the Y axis (see Eq. (2)) and n is an integer. However, n is not limited to an integer. If n is not an integer, the scanning path of the light beam is a so-called Lissajous figure, and the period of irradiation of the same scanning point with the light beam is the reciprocal of the least common multiple of fx and fy, rather than 1/fx. Even in this case, as in the above description, the effect of suppressing the change in the spatial resolution Ry can be obtained by controlling the drive frequency (frame rate) fx.

In the above description, the running direction of the vehicle 150 (see FIG. 1) is the X-axis direction; however, the present invention is not limited thereto. The mirror part 111 of the two-dimensional scanning mirror 106 resonates around the Y axis perpendicular to the running direction (X direction) of the vehicle 150; however, the present invention is not limited thereto, and the mirror part may be resonated and rotationally displaced around another direction.

In the above description, the acceleration sensor 105 detects the acceleration in the running direction of the optical scanning device 100; however, the present invention is not limited thereto and, for example, the acceleration sensor may detect the acceleration in the direction orthogonal to the running direction of the optical scanning device 100.

The acceleration sensor 105 may be capable of detecting the acceleration in directions of two or more axes. As a result, for example, a swing in the Y-axis direction or the Z-axis direction orthogonal to the running direction of the optical scanning device 100 can be detected to adjust the maximum scanning angle in accordance with the magnitude of the swing.

In the above description, the frequency fy of the oscillation around the Y axis of the mirror part 111 of the two-dimensional scanning mirror 106 is defined as the specific resonance frequency fyc (see Eq. (1)). However, the first embodiment of the present invention is not limited thereto, and fy may be a frequency near fyc. Although the applied voltage can certainly most efficiently be converted into oscillation when fy is equal to the resonance frequency fyc; however, even when fy is near the resonance frequency fyc, a relatively large amplitude can be obtained at the same applied voltage.

In the above description, as shown in FIG. 10, the maximum scanning angle $\theta$y is uniformly changed ($\theta$y is expressed as a linear function of Ax) with respect to the change in the acceleration Ax of the optical scanning device 100; however, the first embodiment of the present invention is not limited thereto, and the maximum scanning angle $\theta$y may be determined in accordance with the acceleration Ax.

Modifications

FIG. 17 is a schematic drawing showing a configuration of an optical scanning device according to a first modification of the first embodiment of the present invention, which is generally denoted by 180. In this modification, a beam splitter is not disposed, and the light beam emitted from the light source 101 enters the two-dimensional scanning mirror 106 without passing through a beam splitter.

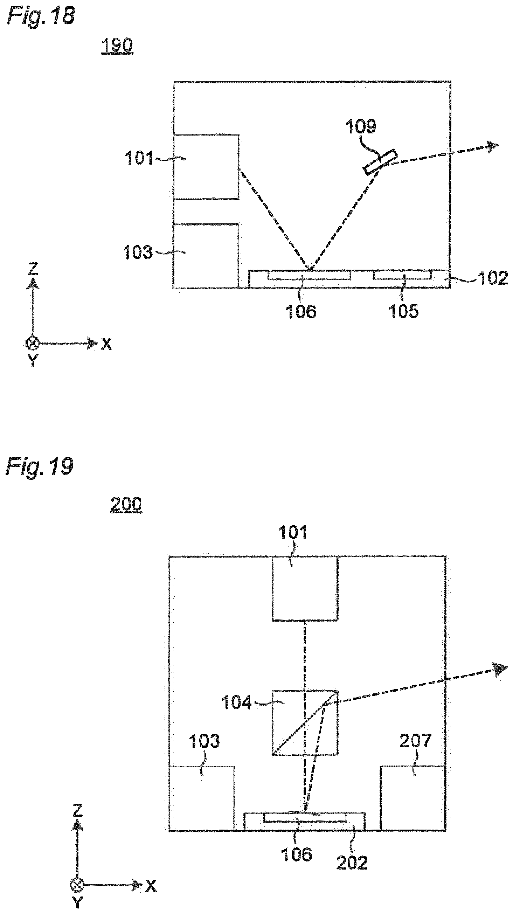

FIG. 18 is a schematic drawing showing a configuration of an optical scanning device according to a second modification of the first embodiment of the present invention, which is generally denoted by 180.

Although a beam splitter is not included also in this modification, a fixed mirror 109 reflecting the light beam entering from the two-dimensional scanning mirror 106 is included instead.

Even when the first modification and the second modification are employed, the first embodiment of the present invention can achieve the same effect, so that the freedom of member arrangement can be increased. The first modification and the second modification are also applicable to a second embodiment, a third embodiment, and a fourth embodiment of the present invention described later.

Second Embodiment

FIG. 19 is a schematic drawing showing a configuration of an optical scanning device according to the second embodiment of the present invention, which is generally denoted by 200. Hereinafter, unless otherwise described, the same constituent elements as those of the first embodiment are denoted by the same reference numerals and will not be described.

Unlike the first embodiment, the optical scanning device 200 includes an angular velocity sensor 207 instead of an acceleration sensor. The angular velocity sensor 207 can detect an angular velocity around a vertical axis (Z axis) (hereinafter simply referred to as "angular velocity") $\Omega$z.

In FIG. 19, only the two-dimensional scanning mirror 106 is formed on a substrate 202, and the angular velocity sensor 207 is disposed separately from the substrate 202. However, the second embodiment of the present invention is not limited thereto, and the angular velocity sensor 207 may also be formed on the substrate 202 by using a MEMS technique.

The optical scanning device 200 may be mounted and used on a vehicle (not shown) as in the first embodiment.

Generally, when a vehicle is running straight, a distance measuring device mounted on the vehicle desirably scans a distant place in the running direction with high spatial resolution. On the other hand, when the vehicle makes a left or right turn or runs in a curve, it is necessary to widely recognize surrounding conditions, so that the distance measuring device mounted on the vehicle desirably scans a wide range.

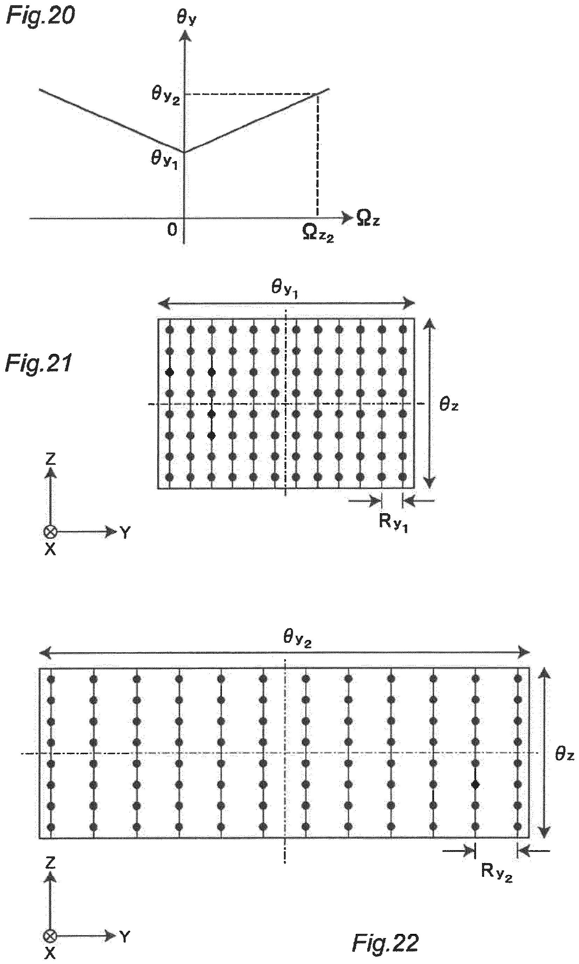

Therefore, as shown in FIG. 20, the maximum scanning angle $\theta$y has hitherto been changed in accordance with the angular velocity Qz such that the maximum scanning angle $\theta$y is reduced when the absolute value of the angular velocity $\Omega$z is small while the maximum scanning angle $\theta$y is increased when the absolute value of the angular velocity $\Omega$z is large.

FIG. 20 shows an example of a relationship between the angular velocity $\Omega$z and the maximum scanning angle $\theta$y when the maximum scanning angle $\theta$y is adjusted in accordance with the angular velocity $\Omega$z. When the vehicle is running straight, the angular velocity Ωz is zero. When the vehicle is turning right, for example, in the case of making a right turn, the angular velocity Ωz indicates a positive value.

When the vehicle is turning left, for example, in the case of making a left turn, the angular velocity Ωz indicates a negative value. A graph of FIG. 20 shows that the maximum scanning angle θy is adjusted to $θy_1$ at the angular velocity Ωz = 0 (during straight running) and is adjusted to $θy_2$ ($>θy_1$) at the angular velocity Ωz = $Ωz_2$.

FIG. 21 is a schematic drawing showing a scanning path and scanning points of the conventional distance measuring device during straight running (at the angular velocity Ωz = 0). FIG. 22 is a schematic drawing showing a scanning path and scanning points of the conventional distance measuring device during turning (in the case of Ωz = $Ωz_2$ in FIG. 20).

In FIG. 22 showing the case of turning, the scanning points are sparser in the Y direction as compared to FIG. 21 showing the case of straight running, and the spatial resolution is deteriorated. As described above, the prior art has a problem of deterioration in the spatial resolution Ry during turning as compared to during straight running.

Therefore, as with the first embodiment, the optical scanning device 200 according to the second embodiment of the present invention controls the drive frequency (frame rate) fx such that the spatial resolution Ry does not deteriorate (i.e., fx×θy is made constant, from Eq. (4)) even when the maximum scanning angle θy is changed in accordance with the angular velocity Ωz of the vehicle.

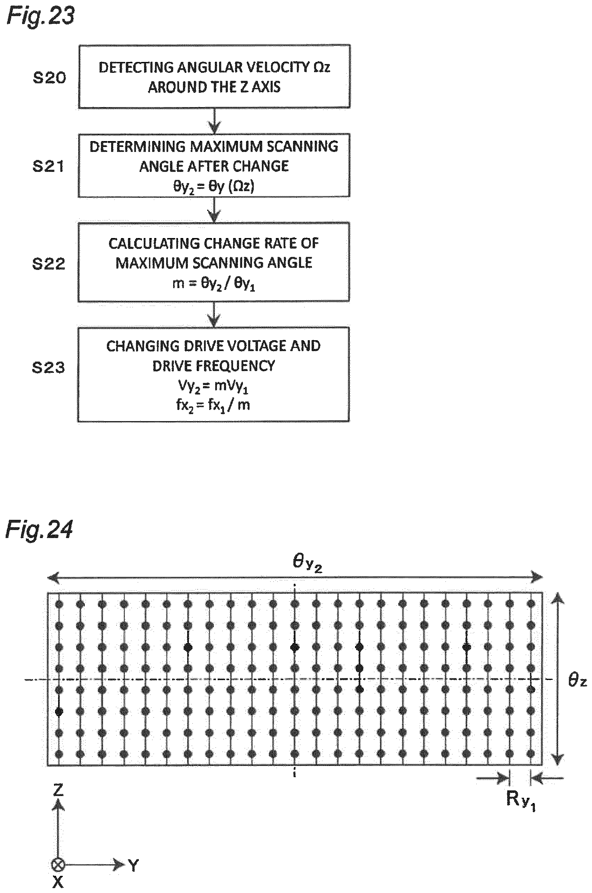

FIG. 23 is a flowchart showing a method of changing the drive frequency (frame rate) fx in accordance with the angular velocity Ωz without deteriorating the spatial resolution Ry. Before the change, the drive frequency (frame rate) fx is $fx_1$, the drive voltage V is $Vy_1$, and the maximum scanning angle θy is $θy_1$. First, at step S20, the angular velocity sensor 207 (see FIG. 19) of the optical scanning device 200 detects the angular velocity Ωz around the Z axis.

At next step S21, the controller 103 (see FIG. 19) determines the maximum scanning angle $θy_2$ after the change based on the detected angular velocity Ωz.

At step S22, the controller 103 calculates the rate (maximum scanning angle change rate) m of the maximum scanning angle $θy_2$ after the change to the maximum scanning angle $θy_1$ before the change (m = $θy_2/θy_1$).

Lastly, at step S23, the controller 103 sets the drive voltage to $Vy_2$ (= $mVyi$) to change the maximum scanning angle to $θy_2$ and changes the drive frequency (frame rate) to $fx_2$ (= $fx_1/m$) to maintain the relationship of Eq. (4).

FIG. 24 is a schematic drawing showing a scanning path and scanning points of the optical scanning device 200 according to the second embodiment of the present invention when the drive frequency fx is adjusted in this way. FIG. 24 shows an example in the case of m = 2, i.e., when the maximum scanning angle θy is doubled. In FIG. 24, it can be seen that the spatial resolution Ry is Ryi, which is not change from the spatial resolution during straight running (see FIG. 21).

As described above, the optical scanning device 100 according to the second embodiment of the present invention can control the maximum scanning angle θy of the light beam based on the angular velocity Ωz and control the drive frequency (frame rate) fx so as to keep the spatial resolution Ry constant even when the maximum scanning angle θy is changed.

In the above description, the angular velocity sensor 207 (see FIG. 19) detects the angular velocity around the vertical direction of the optical scanning device 200; however, the present invention is not limited thereto and, for example, the angular velocity sensor may detect an angular velocity around an axis orthogonal to the vertical direction. The angular velocity sensor 207 may be capable of detecting respective angular velocities around directions of two or more axes. For example, the angular velocity sensor 207 may detect rotation of the optical scanning device 200 around an axis in a horizontal plane.

In the above description, as shown in FIG. 20, the maximum scanning angle θy is uniformly changed with respect to the change in the angular velocity Ωz of the optical scanning device 200; however, the second embodiment of the present invention is not limited thereto, and the maximum scanning angle θy may be determined in accordance with the angular velocity Ωz.

Third Embodiment

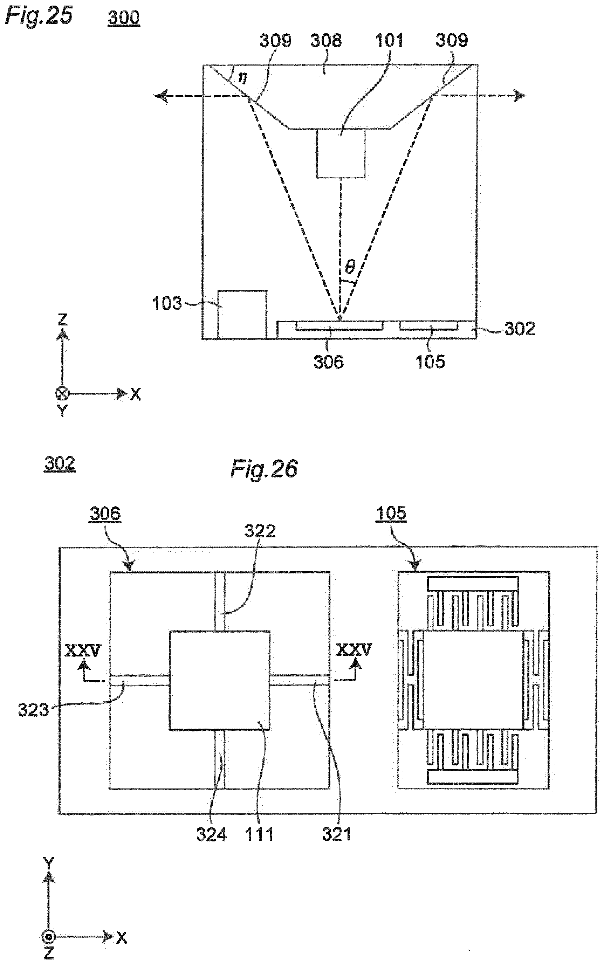

FIG. 25 is a schematic drawing showing a configuration of an optical scanning device according to the third embodiment of the present invention, which is generally denoted by 300. Hereinafter, unless otherwise described, the same constituent elements as those of the first or second embodiment are denoted by the same reference numerals and will not be described.

The light beam emitted from the light source 101 of the optical scanning device 300 is reflected by a two-dimensional scanning mirror 306 disposed on a substrate 302, then reflected by scanning angle conversion means 308, and emitted from the optical scanning device 300. The scanning angle conversion means 308 has an inverted truncated cone shape with a central axis defined along the vertical axis (Z axis), and the light beam is reflected by a conical surface 309 of the scanning angle conversion means 308.

FIG. 26 is a schematic top view of the substrate 302. The substrate 302 includes the acceleration sensor 105 for detecting the acceleration of the optical scanning device 300 and the two-dimensional scanning mirror 306 capable of changing a direction of an optical axis of the incident light beam.

The two-dimensional scanning mirror 306 includes the mirror part 111 and four beams 321 to 324 connected to four points at both ends in the X direction and both ends in the Y direction of the mirror part 111 to support the mirror part 111. Both ends in the X direction and both ends in the Y direction of the mirror part 111 are connected via the respective beams 321 to 324 to the substrate 302. Unlike the first embodiment, the two-dimensional scanning mirror 306 is not provided with a frame (see the frame 113 of FIG. 2).

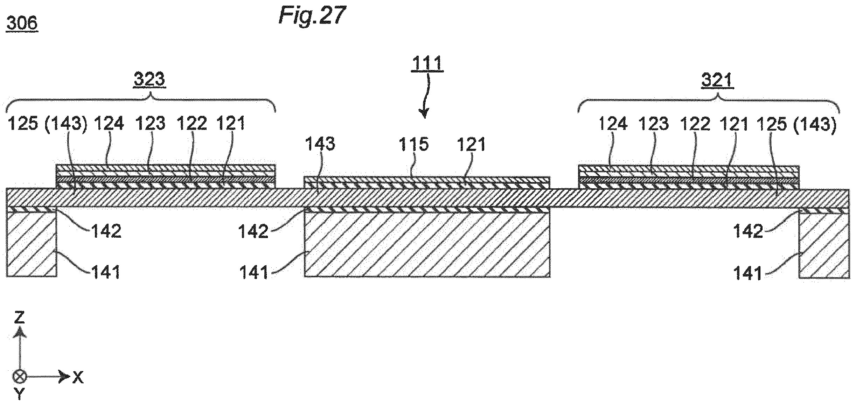

FIG. 27 is a schematic cross-sectional view of the two-dimensional scanning mirror 306 of the substrate 302 of FIG. 26 as viewed in a direction XXV-XXV. The beams 321, 323 (and the beams 322, 324 not shown in FIG. 27) are the same as the beams 120 of the first embodiment described with reference to FIG. 3 and are each composed of a beam base 125 that is a portion of the active layer 143, the insulating film 121 formed on the beam base 125, the first electrode 122 formed on the insulating film 121, the piezoelectric film 123 formed on the first electrode 122, and the second electrode 124 formed on the piezoelectric film 123.

A traveling path of the light beam emitted from the light source 101 will hereinafter be described with reference to FIGS. 25 to 27. Sine-wave voltages having the same frequency and the same amplitude and different in phase are applied to the piezoelectric film 123 via the first electrode 122 and the second electrode 124 (FIG. 27) of the beams 321 to 324 (FIG. 26).

For example, when a sine-wave voltage V(t) is applied to the piezoelectric film 123 of the beam 321, a sine-wave voltage $V(t-\pi/2)$ having a phase delayed by 90° $(\pi/2)$ from V(t) is applied to the piezoelectric film 123 of the beam 322 while a sine-wave voltage $V(t-\pi)$ having a phase further delayed by 90° is applied to the piezoelectric film 123 of the beam 323 and a sine-wave voltage $V(t-3\pi/2)$ having a phase further delayed by 90° is applied to the piezoelectric film 123 of the beam 324.

The beams 321 to 324 are displaced in the Z direction depending on the applied voltage, and therefore, when the sine-wave voltages having different phases are respectively applied to the piezoelectric films 123 of the beams 321 to 324 as described above, the mirror part 111 moves such that a normal line of a surface of the mirror part 111 makes a precession movement (precesses) around the center of the mirror part 111. As a result, the normal line at the center of the surface of the mirror part 111 draws an inverted cone with the vertex defined at the center of the surface of the mirror part 111.

When the light beam vertically enters the substrate 302 while the mirror part 111 is precessing such that the inverted cone has the vertex angle of $\theta/2$, the optical axis of the reflected light beam precesses to draw an inverted cone having the vertex angle of $\theta$ as indicated by a broken line of FIG. 25.

The mirror part 111 has a mechanical specific resonance frequency foc in terms of the precession. Generally, when a structure is allowed to precess, oscillating the structure at a specific resonance frequency can result in efficient conversion of applied energy into oscillation.

Referring to FIG. 25 again, the light beam reflected by the mirror part 111 of the two-dimensional scanning mirror 306 is subsequently reflected by the conical surface 309 of the scanning angle conversion means 308 and emitted from the optical scanning device 300. If a relationship represented by Eq. (5) below is established between an angle $\eta$ formed by the horizontal plane (X-Y plane) and the conical surface 309 of the scanning angle conversion means 308 and the vertex angle $\theta$ of the inverted cone drawn by the optical axis of the light beam, the optical axis of the light beam emitted from the optical scanning device 300 is on the horizontal plane.

$$\theta + 2\eta = 90° \qquad \dots(5)$$

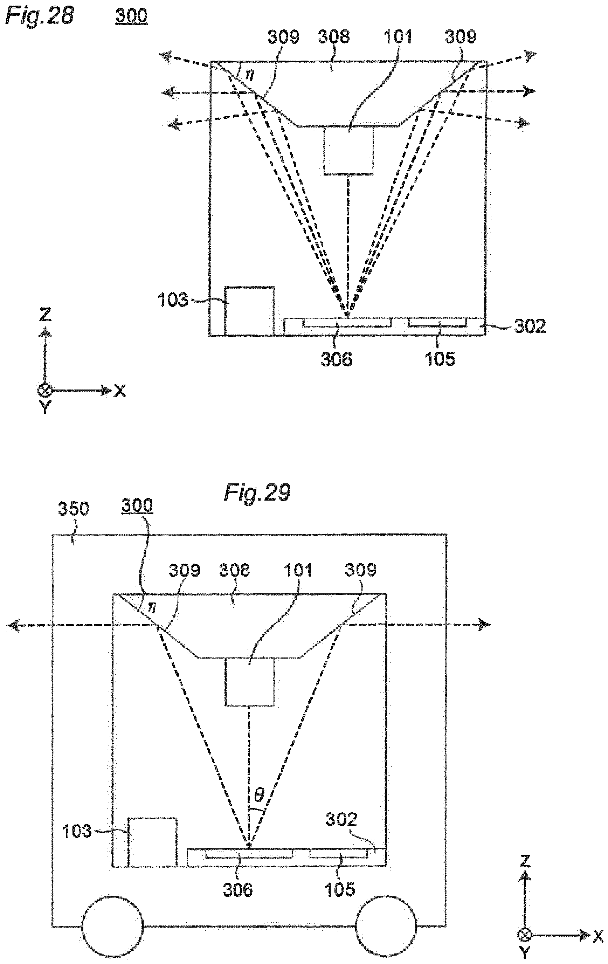

Furthermore, by changing a maximum amplitude $V_A$ of the drive voltage V applied to the piezoelectric films 123 (see FIG. 27) of the beams 321 to 324 (changing to $V_A+\Delta V_A$; hereinafter, $\Delta V_A$ is referred to as "amplitude change amount"), the vertex angle $\theta$ of the inverted cone drawn by the optical axis of the light beam can be changed. As a result, as shown in FIG. 28, scanning can be performed such that the optical axis of the light beam emitted from the optical scanning device 300 moves upward and downward from the horizontal plane.

As described above, the optical scanning device 300 of the third embodiment can advantageously scan the entire circumference in the horizontal direction.

FIG. 29 is a schematic drawing showing a vehicle 350 equipped with the optical scanning device 300. The optical scanning device 300 can scan the entire circumference in the horizontal direction and therefore can advantageously be applied to a distance measuring device mounted on the vehicle 350 and recognizing the surrounding conditions.

An operation of the optical scanning device 300 will hereinafter be described.

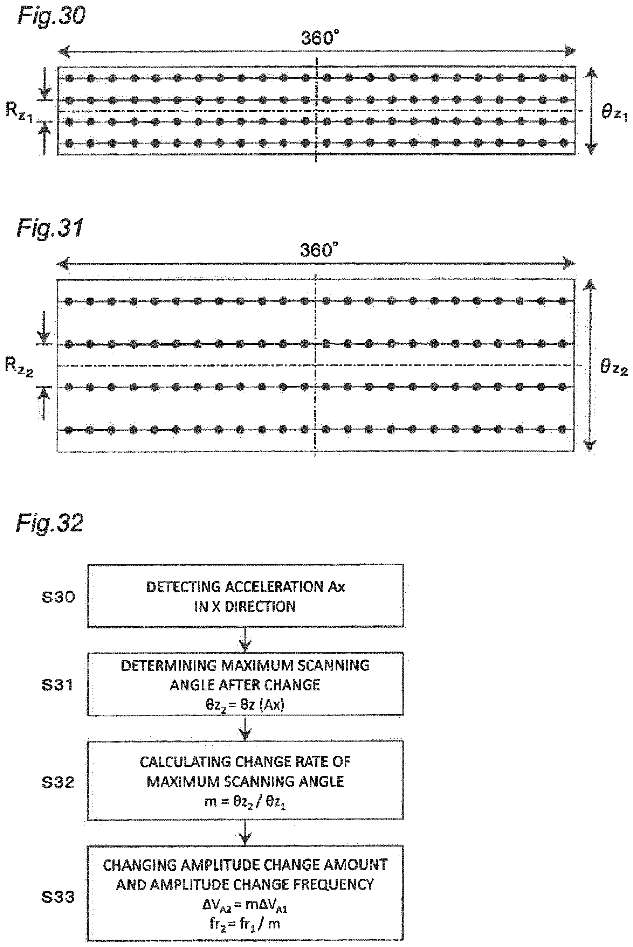

FIG. 30 is a schematic drawing showing an example of a scanning path of a light beam for scanning within a scanning range by the optical scanning device 300 of the third embodiment. In FIG. 30, scanning points irradiated with a pulsed laser beam emitted at regular intervals from the optical scanning device 100 are schematically indicated by black circles. In FIG. 30, a locus of the light beam is indicated by a solid line for convenience of description.

The controller 103 (see FIGS. 25 and 29) applies a sine-wave drive voltage V to each of the piezoelectric films 123 of the beams 321 to 324 (see FIG. 27) such that the mirror part 111 of the two-dimensional scanning mirror 306 precesses at the specific resonance frequency foc. The maximum amplitude $V_A$ of the drive voltage V is controlled to increase and decrease at a frequency fr (hereinafter, this frequency is referred to as "amplitude change frequency" or "frame rate"). Since the optical scanning device 300 can scan the entire circumference in the horizontal direction, the maximum scanning angle in the horizontal direction is 360°. The matrix of the scanning points of FIG. 30 is obtained in this way.

As with the first embodiment, the maximum scanning angle θz is changed by changing the maximum amplitude VA of the drive voltage V in accordance with the acceleration Ax in the running direction of the vehicle 350 (see FIG. 29). When the maximum scanning angle θz is increased from $θz_1$ of FIG. 30 to $θz_2$ ($>θz1$) and the amplitude change frequency fr is not changed, the scanning path of the light beam is as shown in FIG. 31. In FIG. 31, the scanning points are sparser in the Z direction as compared to FIG. 30 showing the case of the smaller maximum scanning angle θz, and a spatial resolution Rz is deteriorated (a spatial resolution $Rz_2$ of FIG. 30 is deteriorated as compared to a spatial resolution $Rz_1$ of FIG. 30).

Therefore, the optical scanning device 300 according to the third embodiment of the present invention controls the amplitude change frequency (frame rate) fr by using Eq. (6) below such that the spatial resolution Ry does not deteriorate even when the maximum scanning angle θz is changed in accordance with the acceleration Ax of the vehicle 350.

$$\mathrm{fr} \times (θz/Rz) = \mathrm{foc} \qquad \ldots(6)$$

When it is desired to keep the spatial resolution Rz constant, fr may be controlled such that $fx \times θy$ is made constant, from Eq. (6), since both Rz and foe are constants.

FIG. 32 is a flowchart showing a method of changing the amplitude change frequency (frame rate) fr in accordance with the acceleration Ax without deteriorating the spatial resolution Rz. Before the change, the amplitude change frequency (frame rate) fr is $fr_1$, the amplitude change amount $\Delta V_A$ is $\Delta V_{A1}$, and the maximum scanning angle θz is $θz_1$. First, at step S30, the acceleration sensor 105 (see FIG. 25) of the optical scanning device 300 detects the acceleration Ax in the X direction.

At next step S31, the controller 103 (see FIG. 25) determines the maximum scanning angle $θz_2$ after the change based on the detected acceleration Ax.

At step S32, the controller 103 calculates the rate (maximum scanning angle change rate) m of the maximum scanning angle $θz_2$ after the change to the maximum scanning angle $θz_1$ before the change (m = $θz_2/θz_1$).

Lastly, at step S33, the controller 103 sets the amplitude change amount to $\Delta V_{A2}$ (= $m\Delta V_{A1}$) to change the maximum scanning angle to $θz_2$ and changes the amplitude change frequency (frame rate) to fr2 (= $fr_1/m$) to maintain the relationship of Eq. (6).

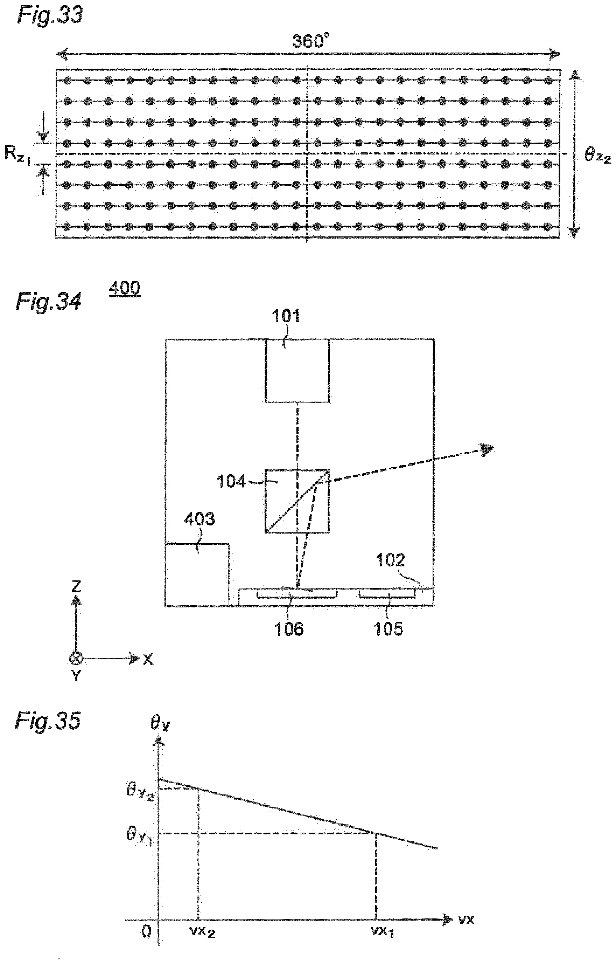

FIG. 33 is a schematic drawing showing a scanning path and scanning points of the optical scanning device 300 of the third embodiment of the present invention when fr of the amplitude change is adjusted in this way. FIG. 33 shows an example in the case of m = 2, i.e., when the maximum scanning angle θz is doubled. In FIG. 33, it can be seen that the spatial resolution Rz is Rzi, which is not change from the spatial resolution before the change (see FIG. 30).

In the above description, the optical scanning device 300 includes the acceleration sensor 105; however, the optical scanning device 300 according to the third embodiment of the present invention may include the angular velocity sensor described in the second embodiment and may determine the maximum scanning angle θz and the amplitude change frequency (frame rate) fr based on the angular velocity.

As described above, the optical scanning device 300 according to the third embodiment of the present invention can control the maximum scanning angle θz of the light beam based on the acceleration or angular velocity and control the drive frequency (frame rate) fr so as to keep the spatial resolution Rz constant even when the maximum scanning angle θz is changed.

Fourth Embodiment

FIG. 34 is a schematic drawing showing a configuration of an optical scanning device according to the fourth embodiment of the present invention, which is generally denoted by 400. Hereinafter, unless otherwise described, the same constituent elements as those of the second or third embodiment are denoted by the same reference numerals and will not be described.

Unlike the first embodiment, the optical scanning device 400 includes a controller 403 controlling the attitude of the two-dimensional scanning mirror 106 based on a velocity. The controller 403 derives a velocity vx in the X direction by integrating the acceleration Ax in the X direction detected by the acceleration sensor 105.

The optical scanning device 400 may be mounted and used on a vehicle (not shown) as in the first embodiment.

Generally, when a vehicle runs at a high velocity, a distance measuring device mounted on the vehicle desirably scans a distant place with high spatial resolution. On the other hand, when the vehicle runs at a low velocity, for example, when the vehicle runs slowly, the running direction of the vehicle is more likely to rapidly change due to left or right turn etc., so that the distance measuring device mounted on the vehicle desirably scans a wide range especially in the horizontal direction.

Therefore, as shown in FIG. 35, the maximum scanning angle θy has hitherto been changed in accordance with the velocity vx of the vehicle such that the maximum scanning angle θy is reduced in the case of a high velocity while the maximum scanning angle θy is increased in the case of a low velocity.

FIG. 35 shows an example of a relationship between the velocity vx and the maximum scanning angle θy when the maximum scanning angle θy is adjusted in accordance with the velocity vx. A graph of FIG. 35 shows that the maximum scanning angle θy is adjusted to $θy_1$

at the time of a velocity $vx_1$ (at high velocity) and is adjusted to $\theta y_2$ ($> \theta y_1$) at the time of a velocity $vx_2$ (at low velocity, $vx_2 < vx_1$).

In the conventional distance measuring device, the scanning path and the scanning points at high velocity are the same as those of FIG. 11 of the first embodiment. The scanning path and the scanning points of the conventional distance measuring device at low velocity are the same as those of FIG. 12. As described above, the spatial resolution at low velocity is deteriorated as compared to the spatial resolution at high velocity.

Therefore, the optical scanning device 400 according to the fourth embodiment controls the drive frequency (frame rate) fx such that the spatial resolution Ry does not deteriorate even when the maximum scanning angle $\theta y$ is changed in accordance with the velocity vx of the vehicle.

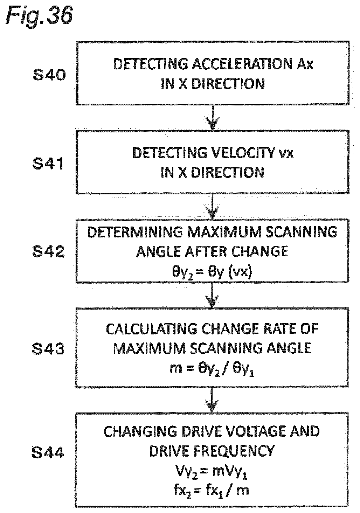

FIG. 36 is a flowchart showing a method of changing the drive frequency (frame rate) fx in accordance with the velocity vx without deteriorating the spatial resolution Ry. Before the change, the drive frequency (frame rate) fx is $fx_1$, the drive voltage V is $Vy_1$, and the maximum scanning angle $\theta y$ is $\theta y_1$. First, at step S40, the acceleration sensor of the optical scanning device 400 detects the acceleration Ax in the X direction. At step S41, the velocity vx in the X-axis direction is calculated through time integration of Ax.

AT next step S42, the controller 403 determines the maximum scanning angle $\theta y_2$ after the change based on the calculated velocity vx.

At step S43, the controller 403 calculates a rate (maximum scanning angle change rate) m of the maximum scanning angle $\theta y_2$ after the change to the maximum scanning angle $\theta y_1$ before the change ($m = \theta y_2 / \theta y_1$).

Lastly, at step S44, the controller 403 sets the drive voltage to $Vy_2$ ($= mVy_1$) to change the maximum scanning angle to $\theta y_2$ and changes the drive frequency (frame rate) to $fx_2$ ($= fx_1/m$) to maintain the relationship of Eq. (4).

In the fourth embodiment, the controller 403 calculates the velocity through time integration of the acceleration Ax detected by the acceleration sensor; however, the present invention is not limited thereto as long as velocity information can be obtained. For example, the optical scanning device 400 may include a velocity sensor not shown, and the velocity may be detected by the velocity sensor. The velocity sensor may obtain the velocity information from the number of rotations of an axle, for example.

As described above, the optical scanning device 400 according to the fourth embodiment of the present invention can control the maximum scanning angle $\theta y$ of the light beam based on the velocity vx and control the drive frequency (frame rate) fx so as to keep the spatial resolution Ry constant even when the maximum scanning angle $\theta y$ is changed.

In the above description, the maximum scanning angle $\theta y$ is uniformly changed with respect to the change in the velocity vx of the optical scanning device 400; however, the fourth embodiment of the present invention is not limited thereto, and the maximum scanning angle $\theta y$ may be determined in accordance with the velocity vx.

## LIST OF REFERENCE SIGNS

| | |
|---|---|
| 100 | optical scanning device |
| 200 | optical scanning device |
| 300 | optical scanning device |
| 400 | optical scanning device |
| 101 | light source |
| 102 | substrate |
| 103 | controller |
| 104 | beam splitter |
| 105 | acceleration sensor |
| 106 | two-dimensional scanning mirror |
| 109 | fixed mirror |
| 111 | mirror part |
| 113 | frame |
| 115 | reflection film |
| 120 | beam |
| 121 | insulating film |
| 122 | first electrode |
| 123 | piezoelectric film |
| 124 | second electrode |
| 125 | beam base |
| 131 | inertial mass body |
| 132 | beam |
| 133 | comb-teeth electrode |
| 134 | fixed comb-teeth electrode; |
| 135 | movable comb-teeth electrode |
| 140 | SOI substrate |
| 141 | support layer |
| 142 | insulating layer |
| 143 | active layer |
| 150 | vehicle |
| 202 | substrate |
| 207 | angular velocity sensor |
| 302 | substrate |
| 306 | tow-dimensional scanning mirror |
| 308 | scanning angle conversion means |
| 321 | beam |
| 322 | beam |
| 323 | beam |
| 324 | beam |
| 350 | vehicle. |

## Claims

1. An optical scanning device comprising:

   - a light source emitting a light;
   - a scanning mirror that includes a reflecting plane reflecting a light entering from the light source and that is allowed to oscillate independently around each of a first axis extending in the reflecting plane and a second axis orthogonal to the first axis and extending in the reflecting plane; and

- a controller controlling the scanning mirror in terms of a first frequency and a first amplitude of oscillation around the first axis as well as a second frequency and a second amplitude of oscillation around the second axis for scanning with the light reflected by the reflecting plane of the scanning mirror,

the optical scanning device scanning, with the light emitted from the light source, the inside of a scanning range defined by a maximum scanning angle in a main scanning direction changing in accordance with the first amplitude and a maximum scanning angle in a sub-scanning direction orthogonal to the main scanning direction and changing in accordance with the second amplitude,

wherein the controller controls the second frequency based on the maximum scanning angle in the sub-scanning direction.

2. The optical scanning device according to claim 1, wherein the controller controls the second frequency and controls the maximum scanning angle in the sub-scanning direction by controlling the second amplitude based on the second frequency.

3. The optical scanning device according to claim 1 or 2, wherein the controller controls the second frequency or the maximum scanning angle in the sub-scanning direction such that a product of the second frequency and the maximum scanning angle in the sub-scanning direction becomes constant.

4. The optical scanning device according to claim 3, wherein the product of the second frequency and the maximum scanning angle in the sub-scanning direction is equal to a product of the first frequency and a spatial resolution that is an angular interval between adjacent main scanning lines.

5. The optical scanning device according to any one of claims 1 to 4, wherein the scanning mirror is adjusted in terms of a phase of oscillation around the first axis and a phase of oscillation around the second axis such that a normal line of the reflecting plane of the scanning mirror passing through an intersection of the first axis and the second axis performs a precession movement around the intersection.

6. The optical scanning device according to any one of claims 1 to 5, wherein the maximum scanning angle in the sub-scanning direction is 360°.

7. The optical scanning device according to any one of claims 1 to 6, further comprising scanning angle conversion means further reflecting the light reflected by the scanning mirror.

8. The optical scanning device according to any one of claims 1 to 7, wherein the controller sets a value of the first frequency to a value equal to a resonance frequency of the scanning mirror around the first axis.

9. The optical scanning device according to any one of claims 1 to 8, wherein the scanning mirror is a MEMS scanning mirror.

10. The optical scanning device according to any one of claims 1 to 9, wherein the scanning mirror is a piezoelectrically-actuated scanning mirror.

11. The optical scanning device according to any one of claims 1 to 10, further comprising an inertial force sensor detecting an inertial force applied into the optical scanning device,
wherein the controller controls the second frequency or the maximum scanning angle in the sub-scanning direction based on the inertial force detected by the inertial force sensor.

12. The optical scanning device according to claim 11, wherein the inertial force sensor is an acceleration sensor detecting an acceleration of the optical scanning device.

13. The optical scanning device according to claim 12, wherein the controller provides control such that when the acceleration detected by the acceleration sensor is larger, the second frequency or the maximum scanning angle in the sub-scanning direction becomes smaller.

14. The optical scanning device according to claim 11, wherein the inertial force sensor is an angular velocity sensor detecting an angular velocity of the optical scanning device.

15. The optical scanning device according to claim 14, wherein the controller provides control such that when an absolute value of the angular velocity detected by the angular velocity sensor is larger, the second frequency or the maximum scanning angle in the sub-scanning direction becomes larger.

16. The optical scanning device according to any one of claims 11 to 15,
wherein the inertial force sensor is a MEMS sensor.

17. The optical scanning device according to any one of claims 11 to 16,
wherein the inertial force sensor and the scanning mirror are integrated on a substrate.

18. The optical scanning device according to any one of claims 1 to 17, further comprising a velocity sensor detecting a velocity of the optical scanning device, wherein the controller controls the second frequency or the maximum scanning angle in the sub-scanning direction based on the velocity detected by the velocity sensor.

19. A method of control for the optical scanning device according to any one of claims 11 to 17, the method comprising the steps of:

> detecting the inertial force by the inertial force sensor; and
> controlling the maximum scanning angle in the sub-scanning direction by controlling the second amplitude of the scanning mirror based on the detected inertial force.

Fig.1

Fig.2

EP 3 767 367 A1

*Fig.3*

106

111

120

125 (143) 124 123 122 121

113 (143)

143 115 121

113 (143)

124 123 122 121 125 (143)

120

142

141

142

141

142

141

Z

Y X

105                                                                    Fig.4

105                                                                    Fig.5

140                                                                    Fig.6

*Fig.7*

*Fig.8*

Fig.9

Fig.10

Fig.11

## Fig.12

## Fig.13

| | |
|---|---|
| S10 | DETECTING ACCELERATION Ax IN X DIRECTION |
| S11 | DETERMINING MAXIMUM SCANNING ANGLE AFTER CHANGE $\theta y_2 = \theta y (Ax)$ |
| S12 | CALCULATING CHANGE RATE OF MAXIMUM SCANNING ANGLE $m = \theta y_2 / \theta y_1$ |
| S13 | CHANGING DRIVE VOLTAGE AND DRIVE FREQUENCY $Vy_2 = mVy_1$ $fx_2 = fx_1 / m$ |

Fig.14

$$\theta y_2$$

$$\theta z$$

$$R y_1$$

Z

Y

X

Fig.15

| S15 | DETECTING ACCELERATION Ax IN X DIRECTION |
|---|---|
| S16 | DETERMINING DRIVE FREQUENCY AFTER CHANGE $fx_2 = fx\,(Ax)$ |
| S17 | CALCULATING CHANGE RATE OF DRIVE FREQUENCY $I = fx_2 / fx_1$ |
| S18 | CHANGING DRIVE VOLTAGE AND MAXIMUM SCANNING ANGLE $Vy_2 = Vy_1 / I$ $\theta y_2 = \theta y_1 / I$ |

*Fig.16*

*Fig.17*

180

*Fig.18*

190

*Fig.19*

200

Fig.20

Fig.21

Fig.22

## Fig.23

| S20 | DETECTING ANGULAR VELOCITY $\Omega z$ AROUND THE Z AXIS |
|-----|--------|

| S21 | DETERMINING MAXIMUM SCANNING ANGLE AFTER CHANGE $\theta y_2 = \theta y (\Omega z)$ |
|-----|--------|

| S22 | CALCULATING CHANGE RATE OF MAXIMUM SCANNING ANGLE $m = \theta y_2 / \theta y_1$ |
|-----|--------|

| S23 | CHANGING DRIVE VOLTAGE AND DRIVE FREQUENCY $Vy_2 = mVy_1$ $fx_2 = fx_1 / m$ |
|-----|--------|

## Fig.24

*Fig.25*    300

*Fig.26*    302

EP 3 767 367 A1

*Fig.27*

306

323                                         111                                         321

125 (143) 124 123 122 121          143    115    121          124 123 122 121 125 (143)

142          142                                              142

141          141                                              141

Z
X
Y

*Fig.28* 300

*Fig.29*

*Fig.30*

360°

$R_{z_1}$      $\theta_{z_1}$

*Fig.31*

360°

$R_{z_2}$      $\theta_{z_2}$

*Fig.32*

| S30 | DETECTING ACCELERATION Ax IN X DIRECTION |
|---|---|
| S31 | DETERMINING MAXIMUM SCANNING ANGLE AFTER CHANGE $\theta_{z_2} = \theta_z (Ax)$ |
| S32 | CALCULATING CHANGE RATE OF MAXIMUM SCANNING ANGLE $m = \theta_{z_2} / \theta_{z_1}$ |
| S33 | CHANGING AMPLITUDE CHANGE AMOUNT AND AMPLITUDE CHANGE FREQUENCY $\Delta V_{A2} = m\Delta V_{A1}$ $fr_2 = fr_1 / m$ |

*Fig.33*

*Fig.34*  400

*Fig.35*

*Fig.36*

$$\boxed{\text{S40} \quad \begin{array}{c} \text{DETECTING ACCELERATION Ax} \\ \text{IN X DIRECTION} \end{array}}$$

$$\boxed{\text{S41} \quad \begin{array}{c} \text{DETECTING VELOCITY vx} \\ \text{IN X DIRECTION} \end{array}}$$

$$\boxed{\text{S42} \quad \begin{array}{c} \text{DETERMINING MAXIMUM SCANNING} \\ \text{ANGLE AFTER CHANGE} \\ \theta y_2 = \theta y \, (vx) \end{array}}$$

$$\boxed{\text{S43} \quad \begin{array}{c} \text{CALCULATING CHANGE RATE OF} \\ \text{MAXIMUM SCANNING ANGLE} \\ m = \theta y_2 / \theta y_1 \end{array}}$$

$$\boxed{\text{S44} \quad \begin{array}{c} \text{CHANGING DRIVE VOLTAGE AND} \\ \text{DRIVE FREQUENCY} \\ Vy_2 = mVy_1 \\ fx_2 = fx_1 / m \end{array}}$$

## INTERNATIONAL SEARCH REPORT

| | International application No. |
|---|---|
| | PCT/JP2018/046305 |

| A. CLASSIFICATION OF SUBJECT MATTER |
|---|
| Int. Cl. G02B26/10(2006.01)i, B81B3/00(2006.01)i, B81B7/04(2006.01)i, G01S7/481(2006.01)i, G01S17/93(2006.01)i, G02B26/08(2006.01)i |

According to International Patent Classification (IPC) or to both national classification and IPC

| B. FIELDS SEARCHED |
|---|
| Minimum documentation searched (classification system followed by classification symbols) |
| Int. Cl. G02B26/10, B81B3/00, B81B7/04, G01S7/481, G01S17/93, G02B26/08 |

Documentation searched other than minimum documentation to the extent that such documents are included in the fields searched
```
Published examined utility model applications of Japan       1922-1996
Published unexamined utility model applications of Japan     1971-2019
Registered utility model specifications of Japan             1996-2019
Published registered utility model applications of Japan     1994-2019
```

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| Y<br>A | JP 2015-90463 A (RICOH OPTICAL IND CO.) 11 May 2015, paragraphs [0003]-[0005], [0014]-[0067], fig. 1 (Family: none) | 1-4, 7-10, 18<br>5-6, 11-17, 19 |
| Y | JP 2000-75030 A (AISIN SEIKI CO., LTD.) 14 March 2000, paragraph [0014] (Family: none) | 1-4, 7-10, 18 |
| Y | JP 11-153664 A (SUMITOMO ELECTRIC INDUSTRIES, LTD.) 08 June 1999, paragraphs [0001]-[0003], [0038] (Family: none) | 1-4, 7-10, 18 |
| A | WO 2016/153687 A1 (GOGGLE INC.) 29 September 2016, entire text, all drawings & JP 2018-49014 A & US 2016/0282468 A1 & EP 3274738 A1 & KR 10-2017-0125107 A & CN 107430195 A | 1-19 |

☒ Further documents are listed in the continuation of Box C.          ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 12.02.2019 | 26.02.2019 |

| Name and mailing address of the ISA/<br>    Japan Patent Office<br>    3-4-3, Kasumigaseki, Chiyoda-ku,<br>    Tokyo 100-8915, Japan | Authorized officer |
|---|---|
| | Telephone No. |

Form PCT/ISA/210 (second sheet) (January 2015)

**INTERNATIONAL SEARCH REPORT**

International application No.

PCT/JP2018/046305

C (Continuation).    DOCUMENTS CONSIDERED TO BE RELEVANT

| Category* | Citation of document, with indication, where appropriate, of the relevant passages | Relevant to claim No. |
|---|---|---|
| A | US 2017/0307736 A1 (OPSYS TECH LTD.) 26 October 2017, entire text, all drawings & WO 2017/184336 A2 | 1-19 |

Form PCT/ISA/210 (continuation of second sheet) (January 2015)

**EP 3 767 367 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016090268 A